Europäisches Patentamt

European Patent Office

Office européen des brevets

(11) Publication number: **0 381 927**
**A2**

## (12) EUROPEAN PATENT APPLICATION

(21) Application number: **90100309.5**

(51) Int. Cl.5: **H01C 7/00, G02F 1/133**

(22) Date of filing: **08.01.90**

The title of the invention has been amended (Guidelines for Examination in the EPO, A-III, 7.3).

(30) Priority: **13.01.89 JP 6446/89**
**04.04.89 JP 85371/89**
**04.04.89 JP 85372/89**
**04.04.89 JP 85373/89**
**04.04.89 JP 85374/89**
**06.11.89 JP 288402/89**

(43) Date of publication of application:
**16.08.90 Bulletin 90/33**

(84) Designated Contracting States:
**DE FR GB**

(71) Applicant: **SEIKO EPSON CORPORATION**
**4-1, Nishishinjuku 2-chome**
**Shinjuku-ku Tokyo-to(JP)**

(72) Inventor: **Ono, Yoshihiro**
**c/o Seiko Epson Corporation 3-5, Owa**
**3-chome**
**Suwa-shi Nagano-ken(JP)**
Inventor: **Matsushima, Fumiaki**
**c/o Seiko Epson Corporation 3-5, Owa**
**3-chome**
**Suwa-shi Nagano-ken(JP)**
Inventor: **Osaka, Tetsuya**
**29-2-4, Shibakubo**
**Tanashi-shi Tokyo-to(JP)**

(74) Representative: **Blumbach Weser Bergen**
**Kramer Zwirner Hoffmann Patentanwälte**
**Radeckestrasse 43**
**D-8000 München 60(DE)**

(54) **Bidirectional non-linear resistor, active matrix liquid-crystal panel using the same, and method for its production.**

(57) A bidirectional nonlinear resistor of this invention has a highly insulating organic film 13 formed on a conductor (11) by the use of an electrolytic solution containing at least a supporting electrolyte and an organic compound soluble in the electrolytic solution and a conductor (14) identical or not identical in kind with the conductor formed on the organic film.

An active matrix liquid crystal panel is produced by forming an electrode of a prescribed pattern on one of a pair of transparent substrates, then forming a highly insulating electrolytic polymer film on the electrode by the electrolytic polymerization process, forming a transparent electrode on the entire surface of the transparent substrate, shaping the transparent electrode after the prescribed pattern thereby forming a conductor/insulator/conductor nonlinear resistor, and thereafter applying the nonlinear resistor fast with a sealing material to the transparent substrate having formed thereon the transparent electrode of the prescribed pattern.

(b)

FIG. 4

# BIDIRECTIONAL NONLINEAR RESISTOR, ACTIVE MATRIX LIQUID CRYSTAL PANEL USING BIDIRECTIONAL NONLINEAR RESISTOR, AND METHOD FOR PRODUCTION THEREOF

## BACKGROUND OF THE INVENTION

### FIELD OF THE INVENTION

This invention relates to a nonlinear resistor usable for all elements which require nonlinearity of resistance. It is usable, for example, as a MIM (metal-insulator-metal) element now utilized as a switching element in liquid crystal display devices or as a switching element in computer grade display devices or TV grade liquid crystal display devices.

### DESCRIPTION OF THE PRIOR ART

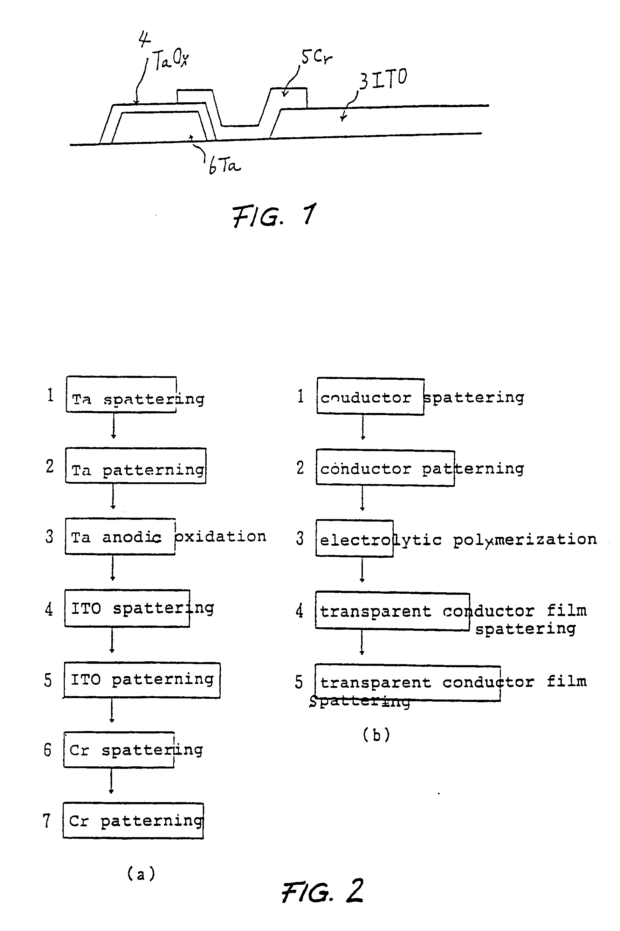

The methods currently used for display of pictures in liquid crsytal televisions are broadly classified under the simple matrix method and the active matrix method. The simple matrix method employs a system which comprises a liquid crystal interposed between two opposed perpendicularly intersecting sets each of a group of ribbonlike electrodes, and drive circuits connected one each to the ribbonlike electrodes. While this method realizes an inexpensive system because of simplicity of structure, it has a problem that the contrast is insufficient because of cross talk. In contrast, the active matrix method employs a system which comprises switches adapted severally to serve individual picture elements and permits retention of voltage. Because of its ability to retain the selected voltage even during the course of a time-shared driving, it is allowed to acquire an ample capacity for display and manifest highly satisfactory properties as to picture qualities such as contrast. It nevertheless suffers from a disadvantage that the structure is complicate and the cost of production is high. In the case of the thin film transistor (TFT), for example, it is difficult to improve the yield of the operation of superposing five to six thin films by the use of at least five photomasks. Recently, therefore, the two-terminal elements which permit improvement of yield and enjoy low production cost have been arresting attention among other active elements. The metal-insulator-metal is representative of the two-terminal elements. The general structure and process of the MIM are shown in Fig. 1 and Fig. 2. The conventional elements have used in their insulating films a lower electrode of TaOx obtained by anodic oxidation. Since the specific dielectric constant is about 26, the element capacitance is as high as 0.1 pF under the general conditions of 5 $\mu$m x 4 $\mu$m of element size and 600 Å of anodic oxide film thickness. This element capacitance is as large as about 1/3 of the liquid crystal capacitance per picture element (200 x 200 $\mu$m).

In the liquid crystal panel of this quality, a voltage applied to the panel is not fully apportioned to the MIM element and the switching property is consequently inferior because the capacity ratio of the liquid crystal to the element is about 3. As the result, there arises a problem that the liquid crsytal panel is inferior in display quality to the TFT panel.

As noted from the process flow sheet of Fig. 2, the MIM element side substrate is produced by the repetition of a photolitho-etching step.

Though this repetition of the step contributes to shorten the production process of the MIM element as compared with that of the TFT element, it nevertheless causes degradation of yield.

Further, the production process under discussion suffers from poor efficiency because it necessitates repeated use of a vacuum device such as for spattering as a film-forming device.

As described above, the conventional technique has the following three problems yet to be solved:

(1) The MIM panel is inferior in display quality to the TFT panel.

(2) Though the production process of the MIM element is simple as compared with that of the TFT element, it is liable to entail degradation of yield because it necessitates repetition of the photolitho-etching step.

(3) The production process of the MIM element is deficient in efficiency because it inevitably relies for the formation of film upon a vacuum device.

## SUMMARY OF THE INVENTION

An object of this invention is to provide an active matrix liquid crystal panel which possesses a picture quality comparable with that of the TFT element and incorporates nonlinear resistors producible inexpensively in a high yield.

The other objects, features, and advantages of this invention will become more apparent to those skilled in the art as the disclosure is made in the following description of preferred embodiments, illustrated in the accompanying diagrams.

## BRIEF DESCRIPTION OF THE DRAWINGS

Fig. 1 is a cross section of the conventional MIM element.

Fig. 2 is a flow diagram comparing the conventional process (a) and the basic process of the present invention, (b) for the formation of respective active elements.

Fig. 3 depicts the active element of this ivnention; (a) a cross section of the active element of this invention and (b) a front view of the active element of this invention.

Fig. 4 depicts a production process of a two-terminal element of this invention and a structure of the element; (a) a flow diagram illustrating the production process, (b) a cross section of a typical two-terminal element of this invention, and (c) a cross section of another two-terminal element of this invention.

Fig. 5 depicts the two-terminal element of this invention; (a) a flow diagram of the production process of the two-terminal element of this invention, (b) a cross section illustrating a typical two-terminal element of the present invention, and (c) a cross section illustrating another typical two-terminal element of this invention.

Fig. 6 is an I/V characteristic diagram of the MIM element described in Example 1.

Fig. 7 is an I/V characteristic diagram of the MIM element described in Example 2.

Fig. 8 is a an I/V characteristic diagram of the MIM element described in Example 3.

In the I-V characteristic diagrams, the broken lines invariably represent data obtained when the underlying electrode on the substrate side had negative polarity and the continuous lines invariably represent data obtained when the same electrodes had positive polarity.

Fig. 9 depicts the active element of this invention; (a) a cross section and (b) a front view. In the diagrams, 11 stands for a conductor (wiring), 12 for an insulator, 13 for an electrolytic polymer film, 14 for a conductor, 15 for an ITO (picture element electrode), 16 for an ITO (wiring), and 17 for a contact hole.

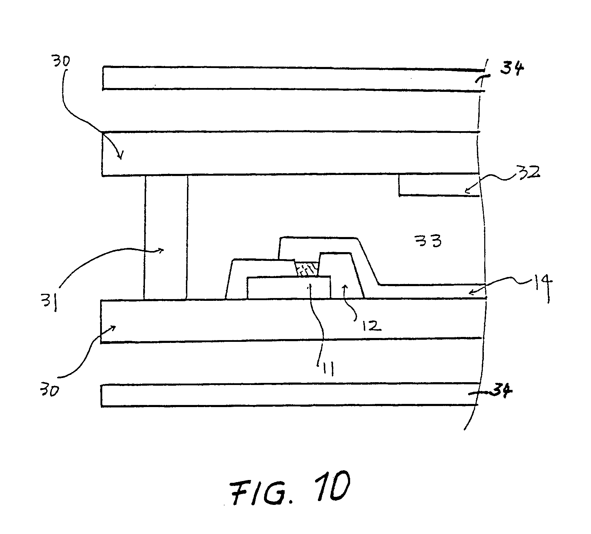

Fig. 10 is a cross section illustrating a liquid crystal panel using a bidirectional nonlinear resistor of this invention, in which 30 stands for a glass substrate, 31 for a sealing agent, 32 for an electrode, and 33 for a liquid crystal.

## DETAILED DESCRIPTION OF THE PREFERRED EMBODIMENTS

The bidirectional nonlinear resistor of this invention is produced by forming on a conductor a highly insulating organic film by electrolytic polymerization using an electrolytic solution containing at least a supporting electrolyte and an organic compound soluble in the electrolytic solution and subsequently forming on the organic film a conductor identical or not identical in kind with the conductor mentioned above. The active matrix liquid crystal panel contemplated by this invention uses this bidirectional nonlinear resistor. Basically, the method employed for the production of the active matrix liquid crystal panel is characterized by a procedure which comprises forming an electrode of a prescribed pattern on one of a pair of transparent substrates, forming a highly insulating electrolytic polymer film on the electrode by electrolytic polymerization process, forming a transparent electrode on the entire surface of the transparent substrate, shaping the transparent electrode after the prescribed pattern mentioned above thereby giving rise to a conductor/insulator/conductor nonlinear resistor, and applying this nonlinear resistor fast with a sealing material to the transparent substrate having the transparent electrode of the prescribed pattern already formed thereon.

The electrolytic polymerization film comes in various physical properties. Among other properties, the diode properties are already known to the art. The bidirectional nonlinear resistor. however, has never been known to the art.

As an element employing an electrolytic polymer film, this invention aims to provide what is possessed of bidirectional nonlinear resistivity, a character heretofore unknown to the art. This invention aims further to provide a method for the production of an active matrix panel using that element.

Now, this invention will be described below sequentially in the order in which the component steps of the production process occur.

(1) A substance destined to form a conductor is applied on a transparent substrate. The conductor may be a transparent conductive film or semiconductor made of one material selected from the group consisting of metals such as Au, Ag, Cu, Ni, Cr, and Ta, alloys of such metals, and oxides such as $SnO_2$ and ITO.

The methods usable for the formation of this film include spattering, vacuum evaporation, CVD, and plating, for example.

The conductor thus formed on the transparent substrate is shaped in the prescribed pattern by the technique of photolitho-etching.

(2) Then, the method for forming an organic film on the conductor by the electrolytic polymerization process will be described below.

The electrolytic polymerization liquid is required to contain therein at least a monomer to be polymerized and a supporting electrolyte. It uses a solvent capable of dissolving the monomer and the supporting electrolyte. The solvents which answer this description include water, alcohols, acetonitrile, propylene carbonates, for example.

The monomers which can be used for the electrolytic polymerization include such aromatic compounds as aniline and phenol which contain an amino group and a hydroxyl group respectively in a benzene ring, such heterocyclic compounds as pyrrole and thiophene, such polycyclic hydrocarbons as azulene and pyrene which possess two or more condensed aromatic rings, and organic compounds possessing an unsaturated bond, for example.

The supporting electrolyte is only required to be capable of imparting ample electroconductivity to the electrolytic solution. The supporting electrolytes which answer this description include $NaClO_4$, $LiClO_4$, $NaBF_4$, $NaOH$, $H_2SO_4$, and $Na_2SO_4$, for example. This supporting electrolyte is incorporated in the electrolytic solution in a concentration in the range of 0.1 to 1 mol/liter.

The methods of electrolysis which are available for the polymerization of the organic substance include the potential sweeping electrolytic method, the constant potential electrolytic method, the constant current electrolytic method, and the AC electrolytic method, for example. This invention is not particular about which of these methods is to be selected.

Two methods are available for the formation of the highly insulating organic film in the present invention.

One of these methods comprises forming the organic film by electrolytic polymerization and subsequently depriving the film of ions. This removal of the ions from the organic film can be attained by applying a potential of reverse polarity to the electrolytic solution in which the organic film has been formed by electrolytic polymerization.

The other method comprises forming a film inactive electrochemically.

The production of the electrochemically inactive film can be accomplished by suitably combining the composition of the electrolytic solution, the conditions of electrolysis, the materials of electrodes, etc.

A phenol or a derivative thereof, for example, produces an electrochemically inactive film when it is electrolytically oxidized with carbon electrodes in an acetonytrile solution (a supporting electrolyte: $NaClO_4$). It forms an inactive polyphenylene oxide film when it is subjected to electrolytic oxidation in basic methanol.

1,2-Diaminobenzene forms an electrochemically inactive film when it is electrolyzed in a neutral solution.

The organic film thus produced is desired to have a thickness in the range of 100 Å to 2 $\mu$m. If the thickness is less than 100 Å, the organic film is so porous as to induce ready formation of a short circuit between the conductors vertically opposed to each other across the organic film. If the thickness exceeds 2 $\mu$m, the produced bidirectional nonlinear resistor offers too high resistance in spite of the nonlinearity thereof for the bidirectional nonlinear resistor to be utilized effectively as an active element for a liquid crystal panel.

By forming on the organic insulator obtained as described above a metallic film of a prescribed pattern by the technique of spattering, vacuum evaporation, or CVD with a compound based on a metal such as, for example, Au, Ag, Cu, Pt, Ni, Co, Cr, Fe, Ta, or Ti or a metal oxide such as, for example, $SnO_2$, $In_2O_3$ ZnO, CdO, ZnS, CdS, or $CdSnO_4$, there is formed a conductor/insulator/conductor nonlinear resistor (two-terminal element).

A few methods other than the basic methods described above are available for the formation of the active element. They are capable of producing the active matrix liquid crystal panel to which this invention is directed. Now, these methods will be briefly described below.

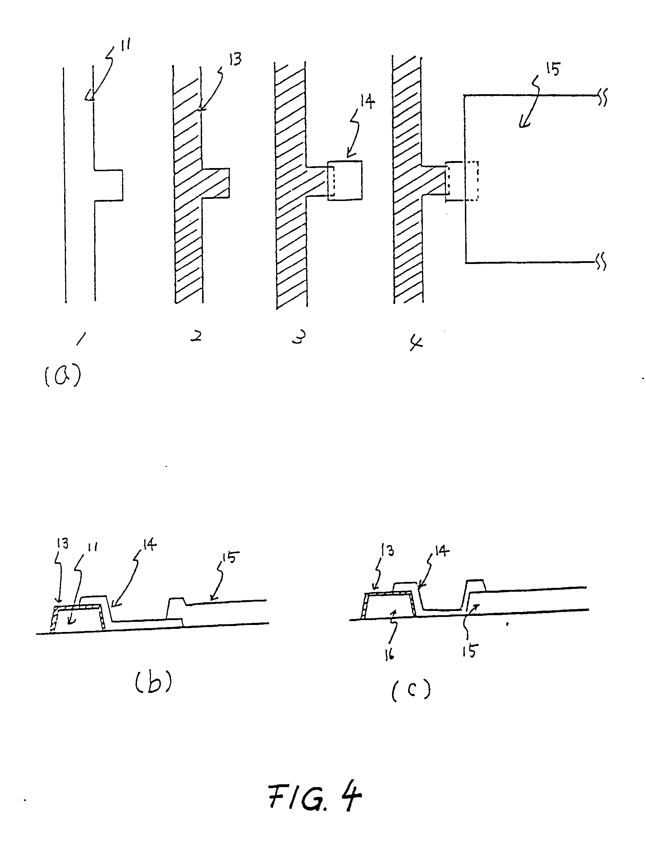

1. One method, as illustrated in Fig. 4 (a), comprises the first step of forming a conductor layer 11 of a prescribed pattern on a transparent substrate, the second step of forming on the electrode mentioned above a highly insulating electrolytic polymer film 13 by electrolytic polymerization process, the third step of forming a conductor 14 identical or not identical in kind with the electrode mentioned above in the prescribed pattern thereby forming a conductor/insulator/conductor nonlinear resistor, and the fourth step of forming a picture element 15 with the transparent conductor film in the shape illustrated in Fig. 4 (a)-4.

Optionally, the active element and the picture element possessing the cross-sectional shape of Fig. 4 (C) may be obtained by simultaneously carrying out the first and fourth steps.

Figs. 4 (b) and (c) are cross sections of active elements formed by the production process shown in Fig. 4 (a). The reference numerals 11 to 15 found in Fig. 4 (b) correspond to the like reference numerals found in Fig. 4 (a). The reference numeral 16 found in Fig. 4 (c) denotes what is produced by first forming the conductor layer and the picture elements with the transparent conductor, forming the electrolytic polymer film 13 only on the conductor layer, and thereafter forming the conductor 14 identical or not identical inkind with the conductor layer in the prescribed pattern.

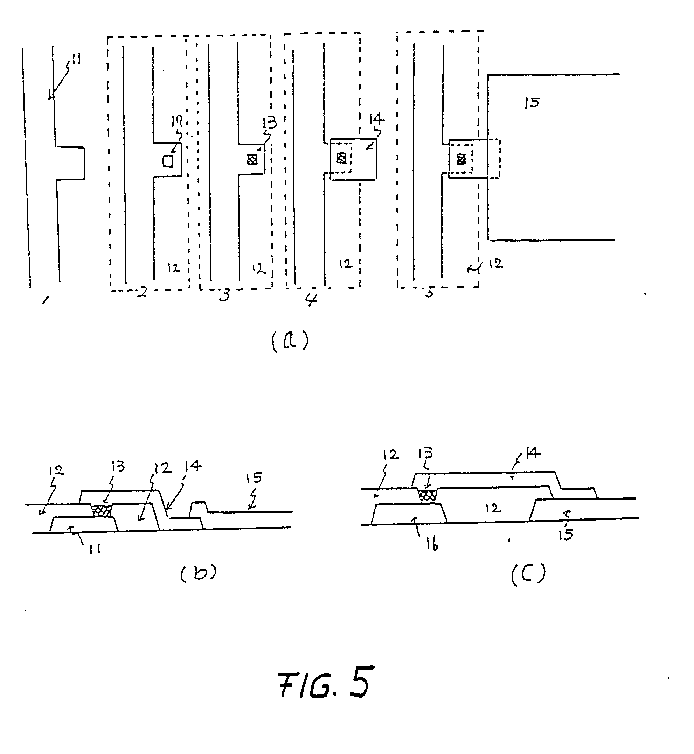

2. Another method comprises the first step of forming on one of a pair of transparent substrates an electrode 11 of a prescribed pattern as illustrated in Fig. 5 (a), the second step of forming a transparent insulating film 12 either on the entire surface of the transparent substrate or only on the electrode and forming in the prescribed part of the insulator film a contact hole communicating with the electrode, the third step of forming an electrolytic polymer film 13 on the electrode through the contact hole by the electrolytic polymerization process, the fourth step of forming a conductor 14 identical or not identical in kind with the electrode in the prescribed pattern thereby forming a conductor/insulator/conductor nonlinear resistor, and the fifth step of forming a picture element 15 with the transparent conductor film in the shape illustrated in Fig. 5 (a).

Optionally, the active element and the picture element possessing the cross-sectional shape of Fig. 5 (C) may be obtained by simultaneously carrying out the first and fifth steps and forming contact holes one each on the electrode and the picture element in the second step.

Figs.5(b) and (c) are cross sections of active elements formed by the process of Fig. 5 (a). The reference numerals 11 to 15 found in Fig. (b) correspond to the like reference numerals found in Figs. 5 (a).

The active element is produced by first forming simultaneously the electorde 16 and the picture element 15 with the transparent conductor, then forming the insulator film, subsequently forming the contact hole 17, forming the electrolytic polymer film through the contact hole, and thereafter forming the conductor 14.

In this process, the transparent insulator film is formed to coat the substrate after the conductor is formed in the prescribed pattern. In the prescribed position of the insulator film, the contact hole is formed so as to communicate with the conductor layer [Fig.5(a) ]. The coating with the insulator layer may be effected on the entire surface or on part of the surafce as illustrated in Figs.5(b) and (c).

The materials which may be used for the transparent insulator film include epoxy resin, acryl resin, polyimide resin, polyamide resin, polyvinyl resin, nylon resin, polyester resin, acetate resin, and phenoxy resin, for example. Optionally, the insulator film may be formed by subjecting an organic metal compound to the dehydrocondensation reaction. The organic metal compounds which are usable for this purpose include those having silicon, titanium, tantalum, chromium, aluminum, indium, tungsten, molybdenum, zirconium, and germanium, for example, as central metals.

The insulator film may be a thermosetting type or an ultraviolet-setting type. The insulator film can be formed by the offset printing, the flexiso printing, or the screen printing.

Optionally, the contact hole may be formed by the photolitho-etching technique after the insulator film is formed on the entire surface.

From this point forward, the process is equal to the basic process.

3. Alternatively in the second process described above, a transparent conductor film may be formed as the conductor in the fourth step as illustrated in Fig. 5 (and the conductor/insulator/conductor nonlinear resistor and the picture element may be simultaneosly formed.

Now, the present invention will be described more specifically below with reference to working examples.

[Example 1]

As an electrolytic polymerization solution, a solution containing 0.1 mol of N-methyl pyrolle and 0.5 ml of sodium perchlorate per liter and using propylene carbonate as a solvent was prepared. As a substratal electrode for the formation of a nonlinear resistor, ITO (indium-tin oxide) formed by vacuum evaporation on a glass substrate was used. The ITO electrode was covered by the use of a photoresist, except for a hole 300 $\mu$m in diameter and a contact part intended for contact with an external electrode.

By using the ITO electrode obtained as described above as a test electrode, a platinum electrode as a counter electrode, and a silver oxide electrode as a reference electrode, the aforementioned solution was electrolytically polymerized. To be specific, constant potential polymerization was performed at +0.9 V with respect to the reference electrode to form a poly-N-methyl pyrrole film 5,000 Å in thickness and then removal of dope was performed thoroughly at -0.4 V with respect to the reference electrode. In consequence of this electrolytic polymerization, the electrolytic polymer film was converted into an insulator film.

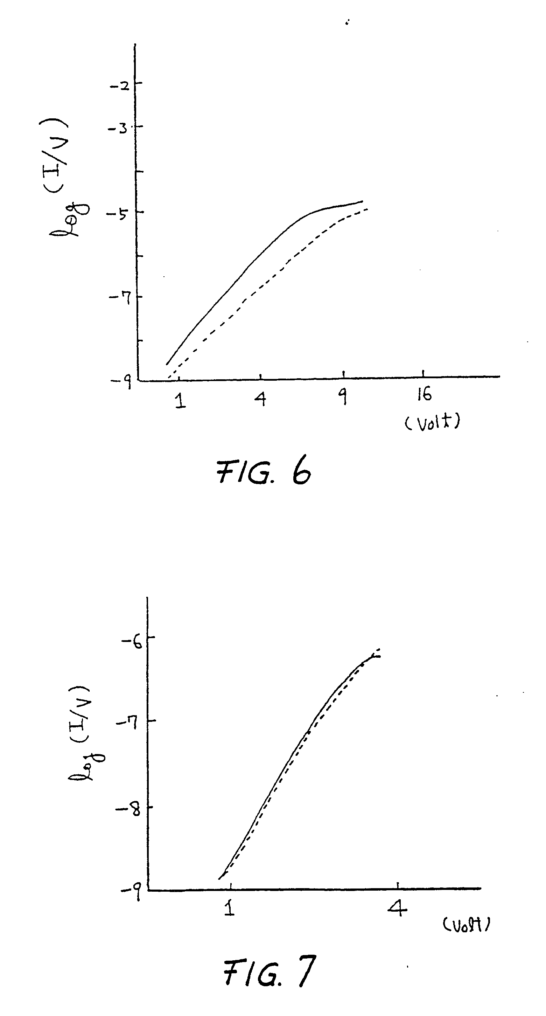

On the electrolytic polymer film thus obtained, an ITO film was superposed by the spattering process to produce a MIM element. This MIM element was tested for I-V characteristics. The characteristic curve thus obtained is shown in Fig. 6. It is clearly noted from the diagram, a bidirectional nonlinear property was obtained without reference to the polarity of the substratal electrode.

[Example 2]

As an electrolytic solution, what was obtained by dissolving in propylene carbonate 0.2 mol of pyrrole and 0.2 mol of lithium perchlorate per liter. An MIM element was formed by following the procedure of Example 1, excepting the electrolytic solution described above was used instead. Specifically, the electrolysis was performed at a constant current.

The I-V characteristic curve obtained of the MIM element is shown in Fig. 7. It is clearly noted from this diagram that a bidirectional nonlinear property was obtained without reference to the polarity of the substratal electrode.

[Example 3]

As an electrolytic solution, what was obtained by dissolving in methanol 0.05 mol of 2,6-dimethyl phenol and 0.3 mol of sodium hydroxide per liter was used. An ITO electrode was formed by following the procedure of Example 1 and the electrolytic solution was subjected to constant potential electrolysis at +2.2 V. The time at which the electric current ceased to flow was taken as the end point of the electrolysis.

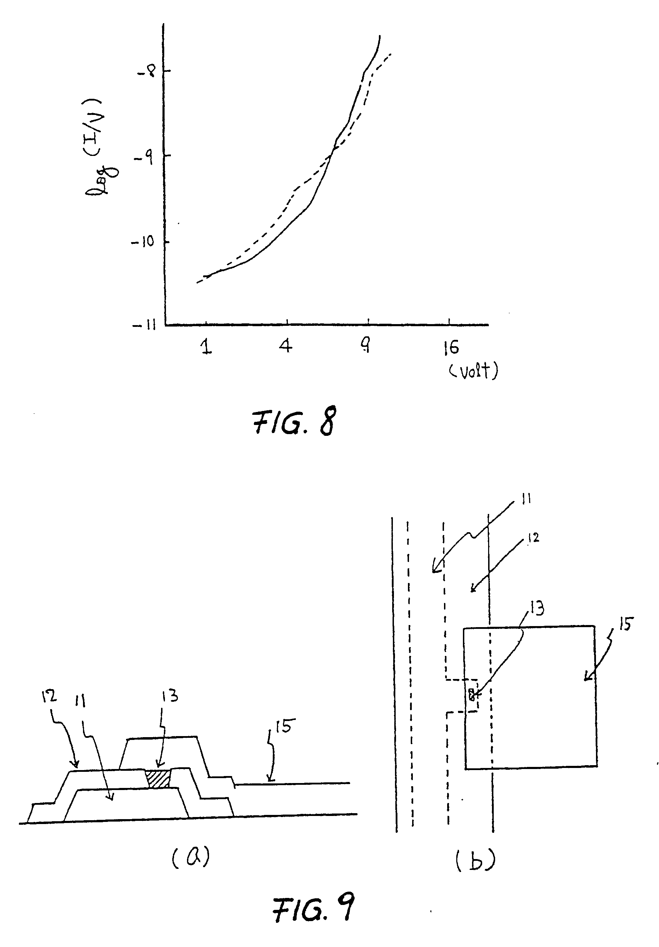

On the polymer film consequently obtained, an ITO film was formed by the spattering process to obtain a MIM element. The MIM element was tested for I-V characteristics. The characteristic curve consequently obtained is shown in Fig. 8. It is clearly noted from the diagram that a bidirectional nonlinear property was obtained without reference to the polarity of the substratal electrode.

[Example 4]

As an electrolytic solution, what was by dissolving in methanol 0.05 mol of phenol and 0.3 mol of sodium hydroxide per liter was used. A MIM element was formed by following the procedure of Example 3 and tested for I-V characteristics. Similar to the other examples, a bidirectional nonlinear resistance was obtained.

[Example 5]

By following the procedure of Example 1, an element having a poly-N-methyl pyrrole layer 1 μm in thickness deposited thereon was formed and tested for the I-V characteristics. Similar to Example 1, a nonlinear resistor was obtained.

[Example 6]

On a glass substrate, an ITO (indium-tin oxide) film measuring 1,500 Å in thickness and provided with a plurality of ribbon electrode patterns was formed by the spattering process.

A solution containing 0.1 mol of N-methyl pyrrole and 0.5 mol of lithium perchlorate per liter and using propylene carbonate as a solvent was prepared as an electrolytic polymerization solution and subjected to bubbling with nitrogen gas. A platinum plate was used as a counter electrode and a silver oxide electrode as a reference electrode. The electrolytic polymerization solution, with the aforementioned ITO-deposited glass substrate immersed therein, was subjected to electrolytic polymerization at a constant potential of +1.0 V for 15 minutes to superpose a poly-N-methyl pyrrole film 4,000 Å in thickness on the ITO film and then electrolyzed at -0.8 V for removal of dope. This removal of the dope was continued until the electric current decreased to 0.

Thereafter, the composite element consequently obtained was washed with purified water and dried at 120°C. On the dry element, an ITO film was formed in a thickness of 500 Å on the entire surface of the glass substrate by the spattering process.

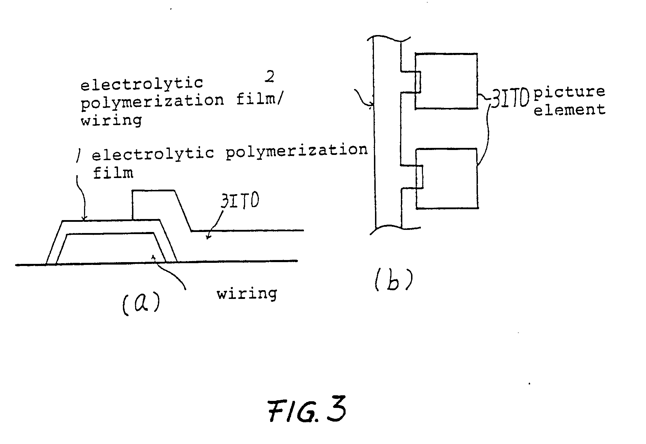

The ITO film was patterned by the photolitho-etching process in the shape of element shown in Figs.3(a) and (b) to produce an element at the prescribed position on the plurality of ribbon electrodes.

This substrate and a glass substrate prepared as a counter substrate by the deposition thereon of a plurality of rows of ITO electrodes were attached fast to each other by subjecting them to the process prescribed for the production of a liquid crystal panel. Thus, an active matrix liquid crystal panel was produced.

This liquid crystal panel was driven with the same drive circuit as used for the conventional MIM panel to determine contrast. It was found that the panel produced herein produced better contrast than the conventional panel.

This improvement is logically explained by a postulate that the poly-N-methyl pyrrole film had a smaller specific dielectric constant and a larger film thickness than the TaOx film.

[Example 7]

As an electrolytic solution, what was obtained by dissolving in methanol 0.05 mol of 2,6-dimethyl phenol and 0.3 mol of sodium hydroxide per liter was used. From this point onward, an ITO electrode on a glass substrate was subjected to constant potential electrolysis at +2.2 V, to form an electrolytic polymer film. The time at which the electric current decreased to 0 was taken as the end point of the electrolysis.

Thereafter, an active matrix liquid crystal panel was produced by following the procedure of Example 6. In the comparative test performed in the same manner as in Example 6, the panel was found to produce better contrast than the conventional MIM panel.

[Example 8]

An active matrix liquid crystal panel was produced by following the procedure of Example 6, excepting the thickness of the electrolytic polymer film was changed to 1,000 Å. It yielded the same results as in Example 6.

[Example 9]

On a glass substrate, a Ta film provided with a plurality of ribbon electrode patterns was formed in a thickness of 1,500 Å by the spattering process.

As an electrolytic polymerization solution, a solution containing in propylene carbonate 0.1 mol of N-methyl pyrrole and 0.5 mol of lithium perchlorate per liter was prepared and subjected to bubbling with nitrogen gas. A platinum plate was used as a counter electrode and a silver oxide electrode as a reference electrode. The electrolytic polymerization solution, with the Ta-deposited glass substrate immersed therein, was subjected to electrolytic polymerization at a constant voltage of +0.1 V for 15 minutes to superpose a poly-N-methyl pyrrole film about 4,000 Å in thickness on the Ta film and then subjected to electrolysis for removal of dope at -0.8 V. The removal of dope was continued until the electric current decreased to 0.

Thereafter, the produced composite element was washed with purified water and dried at 120°C. On the dried element, a Cr alloy film was formed in a thickness of 500 Å throughout the entire surface of the glass substrate by the spattering process.

This Cr alloy film was patterned in the element shape shown in Fig. 4 (a)-3 by the photolitho-etching process, to form an element at the prescribed position on the plurality of ribbon electrodes.

Then, on the element, an ITO (indium-tin oxide) film was formed in a thickness of 500 Å in shape shown in Fig. 4 (a)-4 by the spattering and photolitho-etching processes.

This substrate and a glass substrate prepared as a counter substrate by the deposition thereon of a plurality of rows of ITO electrodes were joined to each other by subjecting them to the process prescribed for the production of a liquid crystal panel, to produce an active matrix liquid crystal panel.

This liquid crystal panel was driven by the use of the same drive circuit as used for the conventional MIM panel, to determine contast. By this the panel of this example produced better contrast than the conventional panel. This improvement is logically explained by a postulate that the poly-N-methyl pyrrole film had a smaller specific dielectric constant and a larger thickness than the TaOx film.

[Example 10]

As an electrolytic solution, what was obtained by dissolving in methanol 0.05 mol of 2,6-dimethyl phenol and 0.3 mol of sodium hydroxide per liter was used. From this point onward, a Ta electrode on a glass substrate was subjected to constant-potential electrolysis at +2.2 V by following the procedure of Example 9, to form an electrolytic polymer film. The time at which the electric current decreased to 0 was taken as the end point of the electrolysis.

An active matrix liquid crystal panel was produced by following the procedure of Example 9 and compared with the conventional MIM panel with respect to contrast. It was consequently found that the panel of this example produced better contrast than the conventional panel.

[Example 11]

On a glass substrate, an ITO (indium-tin oxide) film provided with a plurality of ribbon electrode patterns was formed in a thickness of 2,000 Å by the spattering process.

As an electrolytic polymerization solution, a solution containing in propylene carbonate 0.1 mol of N-methyl pyrrole and 0.5 mol of lithium perchlorate per liter was prepared and subjected to bubbling with nitrogen gas. A platinum plate was used as a counter electrode and a silver oxide electrode as a reference electrode. This solution, the aforementioned ITO-deposited glass substrate immersed therein, was subjected to electrolytic polymerization at a constant potential of +1.0 V for 15 minutes to form a poly-N-methyl pyrrole film in a thickness of about 4,000 Å on the ITO, and then subjected to electrolysis for removal of dope at -0.8 V.

The component element consequently obtained was washed with purified water and dried at 120°C. On the dried element , a Cr alloy film was formed by the spattering process in a thickness of 500 Å throughout the entire surface of the glass substrate.

This Cr alloy film was patterned by the photolitho-etching process in the element shape shown in Figs. 4 (a) and (b) to form an element at the prescribed position on the plurality of ribbon electrodes. This element yielded the same results as in Example 6.

[Example 12]

On a glass substrate, a Ta film provided with a plurality of ribbon electrode patterns was formed by the spattering method in a thickness of 1,500 Å.

On this Ta film, an epoxy acrylate resin (produced by Okuno Seiyaku K.K. and marketed under trademark designation of "SO Clear") was superposed by the spin coating process as a transparent insulator film 2 μm in thickness. This transparent film was exposed to the ultraviolet light through a photomask or a prescribed pattern. As the result, there was formed a contact hole intended for contact with the ITO electrode. This contact hole had a diameter of 10 μm.

Then, as an electrolytic polymerization solution, a solution containing in propylene carbonate 0.1 mol of N-methyl pyrrole and 0.5 mol of lithium perchlorate per liter was prepared and subjected to bubbling with nitrogen gas.

A platinum plate was used as a counter electrode and a silver oxide electrode as a reference electrode. The solution, with the aforementioned Ta-deposited glass substrate immersed therein, was subjected to electrolytic polymerization at a constant potential of + 1.0 V for 15 minutes, to form a poly-N-methyl pyrrole film in a thickness of about 4,000 A on the ITO and then subjected to electrolysis for removal of dope at-0.8 A. This removal of dope was continued until the electric current decreased to 0.

Thereafter, the produced composite element was washed with purified water and dried at 120° C. On the dried element, a Cr film was formed by the spattering process in a thickness of 500 Å throughout the entire surface of the glass substrate.

This Cr film was patterned by the photolitho-etching process in the element shape shown in Fig. 5, to form an element at the prescribed position on the plurality of ribbon electrodes.

Then, on this element, an ITO (indium-tin oxide) film was formed by the spattering and photolitho-etching processes in a thickness of 500 Å in the shape shown in Fig. 5 (a)-4. This substrate and a glass substrate prepared as a counter substrate by the provision thereon of a plurality of rows of ITO electrodes were attached fast to each other by subjecting them to the process prescribed for the production of a liquid crystal panel, to produce an active matrix liquid crystal panel.

This liquid crystal panel was driven by the use of the same drive circuit as used for the conventional MIM panel to determine contrast. By this test, it was found that the panel of this example produced better contrast than the conventional panel.

This improvement is logically explained by a postulate that the poly-N-methyl pyrrole film had a smaller specific dielectric constant and a larger thickness than the TaOx film.

[Example 13]

As an electrolytic solution, what was obtained by dissolving in methanol 0.05 mol of 2,6-dimethyl phenol and 0.3 mol of sodium hydroxide per liter was used. A Ta electrode on a glass substrate was subjected to constant potential electrolysis at + 2.2 V by following the procedure of Example 1, to form an electrolytic polymer film. The time at which the electric current decreased to 0 was taken as the end point of the electrolysis.

Thereafter, an active matrix liquid crsytal panel was produced by following the procedure of Example 12. This panel was found to produce better contrast then the conventional MIM panel.

[Example 14]

On a glass substrate, an ITO (indium-tin oxide) film provided thereon with a plurality of ribbon electrode and a picture element pattern and measuring 2,000 Å in thickness was formed by the spattering process. Thereafter, an insulator film and a contact hole were formed by following the procedure of Example 1.

As an electrolytic polymerization solution, a solution containing in propylene carbonate 0.1 mol of N-methyl pyrrole and 0.5 mol of lithium perchlorate per liter was prepared and subjected to bubbling with nitrogen gas. A platinum plate was used as a counter electrode and a silver oxide electrode was used as a reference electrode. The solution, with the aforementioned ITO-deposited glass substrate imersed therein, was subjected to electrolytic polymerization at a constant potential of + 1.0 V for 15 minutes to form a poly-N-methyl pyrrole film in a thickness of 4,000 Å through a contact hole on the ITO film and then subjected to electrolysis for removal of dope at -0.8 V. This removal of dope was continued until the electric current decreased to 0.

Thereafter, the produced composite element was washed with purified water and dried at 120° C. On the dried element, a Cr alloy film as formed by the spattering method in a thickness of 500 Å throughout the entire surface of the glass substrate.

This Cr alloy film was patterned by the photolitho-etching method in the element shape shown in Fig. 5 (4) , to form an element at the prescribed position on the plurality of ribbon electrodes.

Thereafter, an active matrix liquid crystal panel was produced by following the procedure of example 12 and using the substrate mentioned above. This panel yielded the same results as in Example 12.

[Example 15]

On a glass substrate, an ITO (indium-tin oxide) film provided with a plurality of ribbon electrodes patterns and measuring 1,500 Å in thickness was formed by the spattering process.

On the ITO film, an epoxy acrylate resin (produced by Okuno Seiyaku K.K. and marketed under trademark designation of "SO Clear") was superposed as a clear insulator film in a thickness of 2 $\mu$m by the spin coating process. This insulator film was exposed to ultraviolet light through a photomask of a prescribed pattern. As the result, there was formed a contact hole for contact with the ITO electrode. The contact hole had a diameter of 10 $\mu$m.

Then, as an electrolytic polymerization solution, a solution containing in propylene carbonate 0.1 mol of N-methyl pyrrole and 0.5 mol of lithium perchlorate per liter was prepared.

On the ITO film, an epoxy acrylate resin (produced by Okuno Seiyaku K.K. and marketed under trademark designation of "SO Clear") was superposed as a transparent insulator film by the spin coating process in a thickness of 2 $\mu$m. This insulator film was exposed to ultraviolet light through a photomask of a prescribed pattern. As the result, there was formed a contact hole for contact with the ITO electrode. This contact hole had a diameter of 10 $\mu$m.

Then, as an electrolytic polymerization solution, a solution containing in propylene carboante 0.1 mol of N-methyl pyrrole and 0.5 mol of lithium perchlorate per liter was prepared and subjected to bubbling with nitrogen gas.

A platinum plate was used as a counter electrode and a silver oxide electrode was used as a reference electrode. The solution, with the aforementioned ITO-deposited glass substrate immersed therein, was subjected to electrolytic polymerization at a constant potential of + 1.0 V for 15 minutes to form a poly-N-methyl pyrrole film in a thickness of about 4,000 A on the ITO film, and then subjected to electrolysis for removal of dope at -0.8 V. This removal of dope was continued until the potential decreased to 0.

Thereafter, the composite element consequently obtained was washed with purified water and dried at 120°C. On the dried element, an ITO film was formed by the spattering process in a thickness of 500 Å throughout the entire surface of the glass substrate.

The ITO film was patterned by the photolitho-etching process in the element shape shown in Fig. 9, to form an element at the prescribed position on the plurality of ribbon electrodes.

This substrate and a glass substrate prepared by the provision thereon of a plurality of ITO ribbon electrodes were attached fast to each other by being subjected to the process prescribed for the production of a liquid crystal panel. Consequently, there was produced an active matrix liquid crystal panel.

This liquid crystal panel was driven by the use of the same drive circuit as used for the conventional MIM panel to determine contrast. This panel was found to produce better contrast than the conventional panel.

This improvement is logically explained by a postulate that the poly-N-methyl pyrrole film had a smaller specific dielectric constant and a larger thickness than the TaOx film.

[Example 16]

An active element was produced by following the procedure of Example 15.

As an electrolytic solution, a solution containing in methanol 0.05 mol of 2,6-dimethyl phenol and 0.3 mol of sodium hydroxide per liter was used.

The solution was subjected to electrolysis at a constant potential of + 2.2 V to form an electrolytic polymer film. The time at which the electric current decreased to 0 was taken as the end point of the electrolysis.

Thereafter, an active matrix panel was produced by following the procedure of Example 15. This panel was found to produce better contrast than the conventional MIM panel.

[Example 17]

When an active matrix liquid crystal panel was produced by following the procedure of Example 15 and forming an electrolytic polymer film in a thickness of 1,000 Å, the panel yielded the same results as in Example 15.

[Example 18]

On a glass substrate 0.9 mm in thickness (produced by Corning Corp. of the U.S. and marketed under trademark designation of "Pyrex 7059"), an ITO film 1,500 Å in thickness was formed by the spattering process. By etching this ITO film in a prescribed pattern by the photolitho process, a wiring 35 μm in width was obtained. On this wiring, an epoxy acrylate resin (produced by Okuno Seiyaku K.K. and marketed under trademark designation of "SO Clear") was superposed in a thickness of 3 μm by the spin coating process and then shaped in a prescribed pattern by the photolitho process, a wiring 35 μm in width was obtained. On this wiring, an epoxy acrylate resin (produced by Okuno Seiyaku K.K. and marketed under trademark designation of "SO Clear") was superposed in a thickness of 3 μm by the spin coating process and then shaped in a prescribed pattern by the photolitho process. This pattern had contact holes formed as spaced by a fixed interval on the wiring. The contact holes had a diameter of 18 μm.

Then, an electrolytic polymer film of poly-N-methyl pyrrole was formed on the ITO film through the contact holes (not shown in the diagram and disposed in the electrolytic polymer film). The polymerization was carried out under the conditions shown in Example 1. The polymer film obtained in this case had a thickness of about 5,000 Å.

On the substrate so obtained, an ITO film was formed in a thickness of 600 Å by the spattering process. The ITO film was etched in a prescribed pattern by the photolitho process to obtain a picture element electrode 15 measuring 170 μm in length of side and, at the same time, form a MIM element part.

Then, on a glass substrate 0.9 mm in thickness (produced by Corning Corp and marketed under trademark designation of "Pyrex 7059") destined to form a counter substrate, an ITO film was formed in a thickness of 1,500 Å by the spattering process. By shaping this ITO film in a prescribed pattern, there were produced a wiring and a pair of picture element electrodes on the opposed glass substrates.

The two substrates (MIM element substrate and counter substrate) obtained as described above were dipped in an aqueous 0.1% amino silane (produced by Nippon Soda Co., Ltd. and marketed under product code of "SH6020") solution, washed, fired at 180° C, and then subjected to an orienting treatment by rubbing.

The MIM element substrate and the counter substrate were attached fast to each other by using as a sealing agent a thermosetting type epoxy resin containing glass fibers 6 μm in diameter as a cell gap retaining material. By keeping the two substrates pressed against each other at 150° C for three hours, there was obtained a liquid crystal cell possessing a MIM element.

This liquid crystal cell was filled with liquid crsytal and tightly sealed by the vacuum sealing process. The liquid crystal used in this case was a PCH (phenyl cyclohexane) type liquid crystal (produced by Merck and marketed under product code of "ZLi-1695").

By pasting polarizing sheets 34 one each to the upper and lower surfaces of the liquid crystal cell, there was completed a liquid crystal display panel (LCD).

When this liquid crystal display panel was operated by the same circuit as used for the conventional MIM panel, it exhibited a sufficient display property at 1/480 duty.

## Claims

1. A bidirectional nonlinear resistor characterized by having a highly insulating organic film formed on a conductor by the use of an electrolytic solution containing at least a supporting electrolyte and an organic compound soluble in said electrolytic solution and a conductor identical or not identical in kind with said conductor formed on said organic film.

2. A birdirectional nonlinear resistor according to claim 1, wherein said organic film has a thickness in the range of 100 Å to 2 μm.

3. An active matrix liquid crystal panel characterized by using a birdirectional nonlinear resistor set forth in claim 1.

4. A method for the production of an active matrix liquid crystal panel, characterized by a procedure which comprises forming an electrode of a prescribed pattern on one of a pair of transparent substrates, then forming a highly insulating electrolytic polymer film on said electrode by the electrolytic polymerization process, forming a transparent electrode on the entire surface of said transparent substrate, shaping said transparent electrode after said prescribed pattern thereby forming a conductor/insulator/conductor nonlinear resistor, and thereafter applying said nonlinear resistor fast with a sealing material to said transparent substrate having formed thereon said transparent electrode of said prescribed pattern.

5. A method according to claim 4, wherein said procedure comprises the first step of forming an electrode of a prescribed pattern on a transparent substrate, the second step of forming a highly insulating electrolytic polymer film on said electrode by the electrolytic polymerization process, the third step of forming a conductor identical or not identical in kind with said electrode in said prescribed pattern, and the fourth step of consequently forming a conductor/insualtor/conductor nonlinear resistor and thereafter forming a picture element with said transparent conductor film.

6. A method according to claim 5, wherein the active elements and the picture element are imparted by simultaneously carrying out said first and fourth steps.

7. A method according to claim 4, wherein said procedure comprises the first step of forming an electrode of a prescribed pattern on one of a pair of transparent substrates, the second step of forming a transparent insulating film either on the entire surface of said transparent substrate or only on said electrode thereby forming a contact hole with said electrode in a prescribed part of said insulating film, the third step of forming an electrolytic polymer film through said contact hole on said electrode by the electrolytic polymerization process, the fourth step of forming a conductor identical or not identical in kind with said electrode in said prescribed pattern thereby forming a conductor/insulator/conductor nonlinear resistor, and the fifth step of forming a picture element with a transparent conductor film.

8. A method according to claim 7, wherein the active elements and the picture element are imparted by simultaneously carrying out said first and fifth steps and the formation of said contact hole in said electrode is effected in said second step.

9. A method according to claim 7, wherein a transparent conductor film is used as said conductor in said fourth step and said conductor/insulator/conductor nonlinear resistor and said picture element are simultaneously formed.

10. A method for the production of an active matrix liquid crystal panel, characterized by a procedure which comprises the first step of forming an electrode of a prescribed pattern on a transparent substrate, the second step of forming an electrolytic polymer film on said electrode by the electrolytic polymerization process, the third step of forming a transparent insulating film either on the entire surface of said transparent substrate or on said electrode and forming a contact hole with said electrolytic polymer film on said electrode in a prescribed part of said, insulating film, the fourth step of depriving the doping agent contained in said electrolytic polymer film through said contact hole thereby forming a highly insulating electrolytic polymer film, the fifth step of forming a conductor identical or not identical in kind with said electrode in said prescribed pattern thereby forming a conductor/insulator/conductor nonlinear resistor, and the sixth step of forming a picture element with said transparent conductor film.

11. A method according to claim 10, wherein a transparent conductor film is used as said electrode on said transparent substrate and said electrode and said picture element are formed simultaneously.

FIG. 1

| | |
|---|---|
| 1 | Ta spattering |
| 2 | Ta patterning |
| 3 | Ta anodic oxidation |
| 4 | ITO spattering |
| 5 | ITO patterning |
| 6 | Cr spattering |
| 7 | Cr patterning |

(a)

| | |
|---|---|
| 1 | conductor spattering |
| 2 | conductor patterning |
| 3 | electrolytic polymerization |
| 4 | transparent conductor film spattering |
| 5 | transparent conductor film ~~spattering~~ |

(b)

FIG. 2

electrolytic polymerization film/wiring 2

/ electrolytic polymerization film

3ITO

wiring

(a)

3ITO picture element

(b)

FIG. 3

FIG. 4

(a)

(b)

(C)

FIG. 5

FIG. 6

FIG. 7

FIG. 8

(a)

(b)

FIG. 9

30    34

32

33

31    14

12

11

30    34

FIG. 10